# EUROPÄISCHE PATENTSCHRIFT

(11) **EP 0 662 221 B1**
(45) Veröffentlichungstag und Bekanntmachung des Hinweises auf die Patenterteilung: **11.12.1996**
(21) Anmeldenummer: 93920700.7
(22) Anmeldetag: 10.09.1993
(51) Int. Cl.: G01R 35/04

(54) **PRÜFVERFAHREN FÜR EINEN ELEKTRONISCHEN ELEKTRIZITÄTSZÄHLER**
PROCESS FOR TESTING AN ELECTRONIC ELECTRICITY METER
PROCEDE DE VERIFICATION D'UN COMPTEUR D'ELECTRICITE ELECTRONIQUE

(30) Priorität: 24.09.1992 EP 92116359
(43) Veröffentlichungstag der Anmeldung: 12.07.1995
(73) Patentinhaber: SIEMENS AKTIENGESELLSCHAFT, 80333 München (DE)
(72) Erfinder: DOHMSTREICH, Wolfgang, D-91207 Lauf (DE); WINDSHEIMER, Klaus, D-91443 Scheinfeld (DE)
(86) Internationale Anmeldenummer: EP9302453
(87) Internationale Veröffentlichungsnummer: WO9407155

(56) Entgegenhaltungen:
- EP-A- 0 092 303
- EP-A- 0 420 548
- GB-A- 2 177 805

## Beschreibung

Die Erfindung betrifft ein Verfahren zur Prüfung eines elektronischen Zählers mit optischer Schnittstelle und einen Elektrizitätszähler mit einer Prüfeinrichtung zur Durchführung dieses Verfahrens.

Elektrizitätszähler werden vor ihrem Einsatz einem Funktionstest unterzogen. Hierzu gehört u.a. die Prüfung der Lastkurve der Elektrizitätszähler, bei der genau definierte Prüflasten gemessen werden. Der Meßwert wird an dem Elektrizitätszähler durch eine blinkende Leuchtdiode ausgegeben und von einer Prüfeinrichtung über einen Abtastkopf aufgenommen. In FIG 3 ist das prinzipielle Blockschaltbild eines derartigen Elektrizitätszählers mit der Leistungsanzeige durch eine Blinkdiode dargestellt. Die im Lastkreis gemessenen Größen Strom I und Spannung U werden zunächst in einem Multiplizierer 10 multipliziert und die resultierende Leistung an einen Leistungsfrequenzwandler 3 weitergegeben, an dessen Ausgang Impulse 11 bestimmter Wertigkeit ausgegeben werden. Einem Impuls entspricht dabei eine ganz bestimmte, stets gleiche Energiemenge. Um diese Impulse durch eine Leuchtdiode 16 auch noch bei Starklast für das Auge sichtbar zu machen, sollte die Blinkfrequenz hierbei maximal 10 Hz betragen. Dementsprechend müssen die Impulse 11 durch einen Teiler 13 heruntergeteilt werden, so daß Impulse 12 mit solcher Impulswertigkeit vorliegen, daß eine für das Auge noch wahrnehmbare Blinkfrequenz eingehalten wird. Die Impulse 12 werden einem weiteren Teiler 14 zugeführt, durch den ein anschließendes Zählwerk 15 angesteuert wird. Zur Aufnahme des Meßwerts wird, wie erwähnt, mittels eines Abtastkopfes der Prüfeinrichtung die Blinkdiode 16 abgetastet. Bei Messung von Kleinlasten stellt sich eine entsprechend niedrige Blinkfrequenz ein, so daß die Meßdauer verhältnismäßig lang ist. Von der technischen Realisierung her erfordert die Anwendung einer roten Leuchtdiode als Blinkdiode den geringsten Aufwand, da hierfür bereits geringe Sendeleistungen ausreichen und andererseits ein einfacher Abtastkopf genügt. Wegen der möglichen Verwechslung der roten Leuchtdiode mit einem Warnsignal für Störzustände und Fehlerfälle besteht jedoch seitens der Kunden der Wunsch, grüne oder orangefarbene Leuchtdioden einzusetzen. Hiermit ergeben sich jedoch Probleme bei der Abtastung, so daß besondere und kostenaufwendigere Abtastköpfe notwendig sind.

Ein weiterer derartiger Zähler ist aus der GB-A-2 177 805 bekannt, wobei dort ein Anzeigeelement mit zwei Leuchtdioden vorgesehen ist, die über ein vorgegebenes Teilerverhältnis mit Impulsen unterschiedlicher Frequenz angesteuert werden.

Das geschilderte Problem ist sowohl bei Ferrariszählern als auch bei elektronischen Elektrizitätszählers bekannter Bauart anzutreffen. Letztere weisen üblicherweise eine bidirektionale Infrarot-Schnittstelle auf, über die Daten aus dem Elektrizitätszähler abgerufen oder in diesen eingegeben werden können. Über diese Schnittstelle wird dem Zähler ein Anforderungstelegramm geschickt, auf das er antwortet, indem er z.B. die Zählwerke oder auf Tastendruck alle Daten aussendet. Für diese Funktion wird ein von dem oben erwähnten unterschiedlicher Abtastkopf benötigt.

Der Erfindung liegt die Aufgabe zugrunde, ein Verfahren zur Prüfung eines elektrischen Elektrizitätszählers obengenannter Art zu schaffen, das eine Verkürzung der Prüfdauer ermöglicht und den Aufwand für die Prüfeinrichtung mindert. Eine weitere Aufgabe der Erfindung besteht darin, einen Elektrizitätszähler zur Durchführung eines solchen Verfahrens zu schaffen. Die erste Aufgabe wird durch ein Verfahren mit den Merkmalen nach Anspruch 1 erreicht. Dies wird erreicht durch ein Verfahren mit den Merkmalen nach Anspruch 1. Hiermit kann außerdem auf den Abtastkopf zur Abtastung der Blinkdiode verzichtet werden, d.h. zum Test des Zählers genügt der ohnehin erforderliche Abtastkopf für die optische Schnittstelle.

Für die Messung von mittlerer und starker Last kann die Blinkfrequenz der Leuchtdiode zur Anzeige der Leistung noch genügend hoch sein, so daß eine Aufschaltung der Zählerimpulse an der Leuchtdiode auf die Infrarotschnittstelle gemäß Anspruch 2 als ausreichend angesehen wird.

Eine besonders vorteilhafte Ausführungsform besteht, wenn mit dem Testtelegramm die Zählerimpulse für eine vorbestimmte Dauer auf die Infrarotsendediode geschaltet werden und wenn nach Ablauf diester Dauer dem Zähler über seine optische Schnittstelle ein weiteres Testtelegramm eingegeben wird, das die Ausgabe von Zustandsdaten des Zählers über dieselbe optische Schnittstelle als codiertes Statuswort zur Folge hat. Die Zustandsdaten werden zweckmässigerweise in einem Statusregister abgelegt.

Eine Abkürzung der Prüfdauer für die Messung der Lastkurve und der anschließenden Statusabfrage wird erreicht, wenn die Statusabfrage direkt im Anschluß an die Zählermessung erfolgt, wenn diese vor Ablauf der vorbestimmten Dauer beendet ist und wenn hierzu bei Beendigung der Zählermessung die Prüflast abgeschaltet wird, was eine Unterbrechung des Blinkens der Leuchtdiode zur Folge hat und wenn während dieser Unterbrechung das weitere Testtelegramm zur Statusabfrage über die optische Schnittstelle in den Zähler eingegeben wird.

Bei der Messung von Kleinlasten ergibt sich eine entsprechend niedrige Blinkfrequenz der Blinkdiode, was zu langen Prüfzeiten führt. Um dies zu vermeiden ist es vorteilhaft, wenn auf die Infrarotsendediode der optischen Schnittstelle Zählerimpulse geschaltet werden, die gegenüber den das Blinken der Leuchtdiode bewirkenden Zählerimpulsen eine höhere Impulswertigkeit haben.

Eine voll umfassende Information über den Zustand des Zählers erhält man, wenn das Statuswort den Zustand auch der Steuerleitungen eines Mikrocomputers im Zählers beinhaltet.

Die weitere Aufgabe wird durch einen Elektrizitätszähler mit den Merkmalen nach Anspruch 8 gelöst. Dieser umfaßt zur Durchführung des oben beschriebenen Verfahrens eine Prüfeinrichtung eine optische Schnittstelle zum Datenaustausch bei der Zählermessung nach Beaufschlagung mit einer Prüflast und einen Mikrocomputer, der bei Empfang eines Testtelegramms zur Zählermessung über die optische Schnittstelle in einen Testbetrieb schaltet, der eine Aufschaltung von Zählerimpulsen, die in ihrer Impulswertigkeit der gemessenen Energiemenge an der Prüflast entsprechen, auf die Infrarot-Sendediode der optischen Schnittstelle bewirkt.

Gemäß einer Weiterbildung sind die Zustandsdaten des Elektrizitätszählers durch Übertragung eines Statusworts über die optische Schnittstelle abfragbar.

Außerdem ist es vorteilhaft, wenn zur Abfrage der Zustandsraten des Elektrizitätszählers ein weiteres Testtelegramm dient.

Die Erfindung wird im folgenden anhand eines Ausführungsbeispiels näher erläutert. Es zeigen:
- FIG 1: ein grundsätzliches Schema eines erfindungsgemäßen elektronischen Zählers mit optischer Schnittstelle,
- FIG 2: ein Ablaufdiagramm des obengenannten Verfahrens,
- FIG 3: ein Blockschaltbild eines Elektrizitätszählers nach bekannter Bauart.

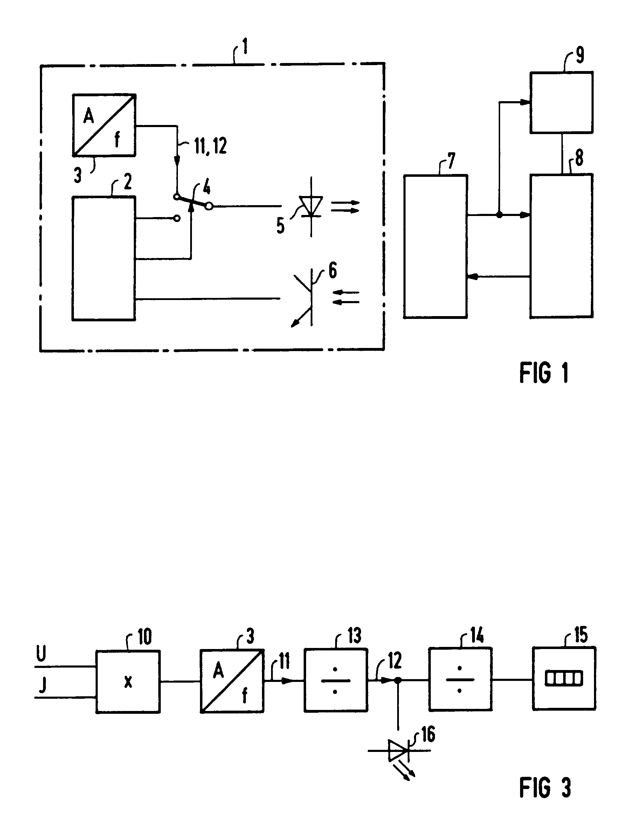

FIG 1 zeigt einen Elektrizitätszähler 1 mit optischer Schnittstelle (IR-Schnittstelle), die eine Infrarot-Sendediode 5 und einen Infrarot-Empfänger 6 umfaßt. Zum Elektrizitätszähler 1 gehört ein Mikrocomputer 2 und ein Leistungsfrequenzwandler 3, wie er z.B. auch in FIG 1 dargestellt ist. Der optischen Schnittstelle 5,6 gegenüberliegend ist eine Prüfeinrichtung mit einem Optokopf 7, der mit einer Computerprüfstation 8 und einem Fehlerrechner 9 in Verbindung steht. Dabei stellt der Optokopf 7 die Sende- und Empfangseinrichtung der gesamten Prüfeinrichtung dar.

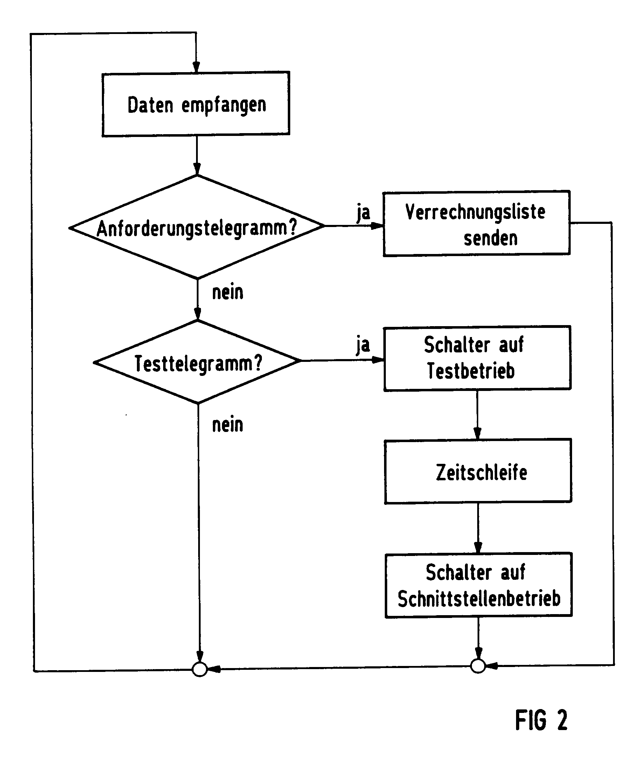

Die Zählermessung über die optische Schnittstelle 5,6 erfolgt gemäß nachstehendem Verfahren, dessen Ablauf vereinfacht in FIG 2 wiedergegeben ist. Danach empfängt der Mikrocomputer 2 des Zählers 1 über die optische Schnittstelle 5,6 Daten. Es sind im vorliegenden Ablaufdiagramm ein allgemeines Anforderungstelegramm und ein Testtelegramm vorgesehen.

Bei Empfang des Anforderungstelegramms sendet der Mikrocomputer 2 über die Infrarot-Sendediode 5 eine Verrechnungsliste mit seinen Registerinhalten, wie z.B. den Zählwerkstand. Diese Funktion ist bei Elektrizitätszählern moderner Bauart bereits bekannt. Das erfindungsgemäß neu hinzukommende Testtelegramm (siehe Ablaufdiagramm FIG 2) bewirkt, daß der Mikrocomputer 2 für eine vorbestimmte Dauer in den Testbetrieb schaltet, bei dem die Impulse 11 oder 12 (siehe FIG 1) über einen Schalter 4 an die Infrarotsendediode 5 weitergeleitet werden. Der Optokopf 7 detektiert diese Impulse und leitet sie an den Fehlerrechner 9 weiter. Nach Ablauf einer Zeitschleife oder wenn die Prüfeinrichtung ein Telegramm zum Abbruch sendet, wird wieder in den normalen Schnittstellenbetrieb übergegangen, d.h. der Schalter 4 in seine Ausgangsposition zurückgestellt.

Wie erwähnt, können Zählerimpulse 11, 12 unterschiedlicher Impulswertigkeit aufgeschaltet werden. Anstelle der niederwertigen Zählerimpulse an der Leuchtdiode 16 gemäß FIG 3 ist es besonders bei der Messung von Kleinlasten zur Verkürzung der Prüfdauer von Vorteil, die höherwertigen Zählerimpulse 11 zur Messung aufzuschalten. Über die Infrarotschnittstelle kann vorgegeben werden, welche Zählerimpulse bestimmter Wertigkeit ausgegeben werden sollen. Diese Anpassungsmöglichkeit ist auch deshalb unbedingt erforderlich, um gegebenenfalls eine Abstimmung auf die Verarbeitungsgeschwindigkeit der Prüfeinrichtung vornehmen zu können.

Das vorbeschriebene Verfahren ermöglicht eine automatische Auslesung der Zählwerksdaten über die Infrarotschnittstelle. Über dieselbe Schnittstelle kann auch eine Parametrierung des Elektrizitätszählers vorgenommen werden.

Neben der Prüfung der Lastkurve des Zählers ist auch die Abfrage weiterer Zustände des Zählers, wie z.B. der Zustand seines Rundsteuerempfängers, von Interesse. Dieser kann drei Zustände einnehmen, die durch eine Leuchtdiode dem Ableser des Zählers angezeigt werden. Stattdessen ist es jedoch auch möglich, mit einem Statuswort über die Infrarotschnittstelle 5, 6 den Zustand des Rundsteuerempfängers an die Prüfeinrichtung weiterzugeben. Das Statuswort kann selbstverständlich noch weitere Zustandsinformationen beinhalten. Hierzu gehören z.B. die Abfrage, ob der Lastzustand oberoder unterhalb der Anlaufschwelle ist sowie auch die Abfrage der Tarife, d.h. die momentane Einstellung auf Hoch- oder Niedertarif. Auch eine Überprüfung des Mikrocomputers 2 und seiner Steuereingänge ist über diese Infrarotschnittstelle 5, 6 möglich. Hierzu werden die Steuereingänge angesteuert, und die Reaktion auf die eingegebenen Signale wird abgefragt.

Zur Einleitung der Statusabfrage ist ein weiteres, im Ablaufdiagramm nicht erwähntes weiteres Testtelegramm vorzusehen. In diesem Modus hat der Schalter 4 dieselbe Stellung wie bei der Ausgabe der Verrechnungsliste im Schnittstellenbetrieb.

Besondere Vorkehrungen sind zu treffen, wenn die Statusabfrage sich nach Beendigung der Zählermessung, d.h. vor Ablauf der Zeitschleife, direkt anschließen soll. In diesem Fall muß die Ausgabe von Zählerimpulsen über die Leuchtdiode 16 (FIG 1) abgebrochen bzw. unterdrückt werden, um eine störende Einkopplung dieser optischen Signale im Infrarotempfänger 6, der z.B. als Empfangs-Phototransistor ausgeführt ist, zu verhindern. Aufgrund einer solchen Einkopplung wäre ein an der JR-Schnittstelle eingegebenes Anforderungs- oder Testtelegramm zur Einleitung der Statusabfrage nicht mehr lesbar. Daher muß die Zählerimpuls-Ausdauer auf eine gewisse Dauer begrenzt werden, nach deren Ablauf Daten, d.h. Telegramme vom Zähler 1 empfangen werden können. Eine andere Möglichkeit besteht, von der Prüfeinrichtung her die Leistung zu reduzieren, um die Zählerimpulse ganz wegzunehmen oder nur sehr langsam laufen zu lassen.

Nach dem beschriebenen Verfahren kann ein vollautomatischer Test des Zählers durchgeführt werden. Mit Hilfe eines Testtelegramms werden die Zählerimpulse auf die Infrarotschnittstelle 5, 6 geschaltet. Ein weiteres Testtelegramm kann zur Statusabfrage des Elektrizitätszählers dienen.

## Patentansprüche

1. Verfahren zur Prüfung eines elektronischen Elektrizitätszählers (1) mit optischer Schnittstelle (5, 6), dem zur Zählermessung nach Beaufschlagung mit einer Prüflast über die optische Schnittstelle (5, 6) ein Testtelegramm eingegeben wird, welches eine Aufschaltung von Zählerimpulsen (11, 12), die in ihrer Impulswertigkeit der gemessenen Energiemenge an der Prüflast entsprechen, auf die Infrarot-Sendediode (5) der optischen Schnittstelle bewirkt.

2. Verfahren zur Prüfung eines elektronischen Elektrizitätszählers nach Anspruch 1, **dadurch gekennzeichnet**, daß mit der Eingabe des Testtelegramms auf die Infrarot-Sendediode (5) der optischen Schnittstelle die Zählerimpulse (12) geschaltet werden, die einer Leuchtdiode (16) mit einer maximalen Betriebsblinkfrequenz von bis zu 15 Hz zur optischen Energieverbrauchsanzeige zugeführt werden.

3. Verfahren zur Prüfung eines elektronischen Elektrizitätszählers nach Anspruch 1 oder 2, **dadurch gekennzeichnet,** daß mit dem Testtelegramm die Zählerimpulse (12) für eine vorbestimmte Dauer auf die Infrarot-Sendediode (5) geschaltet werden und daß nach Ablauf dieser Dauer dem Zähler (1) über seine optische Schnittstelle (5, 6) ein weiteres Testtelegramm eingegeben wird, das die Ausgabe von Zustandsdaten des Zählers (1) über dieselbe optische Schnittstelle (5, 6) als codiertes Status-Wort zur Folge hat.

4. Verfahren zur Prüfung eines elektronischen Elektrizitätszählers nach einem der vorangehenden Ansprüche, **dadurch gekennzeichnet**, daß die Zustandsdaten in einem Statusregister abgelegt sind.

5. Verfahren zur Prüfung eines elektronischen Elektrizitätszählers nach Anspruch 3 oder 4, **dadurch gekennzeichnet,** daß die Statusabfrage direkt im Anschluß an die Zählermessung erfolgt, wenn diese vor Ablauf der vorbestimmten Dauer beendet ist und daß hierzu bei Beendigung der Zählermessung die Prüflast abgeschaltet wird, was eine zumindest vorübergehende Unterbrechung des Blinkens der Leuchtdiode (16) zur Folge hat und daß während dieser Unterbrechung das Testtelegramm zur Status-Abfrage über die optische Schnittstelle (5, 6) in den Zähler (1) eingegeben wird.

6. Verfahren zur Prüfung eines elektronischen Elektrizitätszählers nach einem der vorangehenden Ansprüche, **dadurch gekennzeichnet,** daß auf die Infrarot-Sendediode (5) der optischen Schnittstelle Zählerimpulse (11) geschaltet werden, die gegenüber den das Blinken der Leuchtdiode (16) bewirkenden Zählerimpulsen (12) eine höhere Impulswertigkeit haben.

7. Verfahren zur Prüfung eines elektronischen Elektrizitätszählers nach einem der vorangehenden Ansprüche, **dadurch gekennzeichnet,** daß das Status-Wort eine Aussage über den Zustand der Steuerleitungen eines Mikrocomputers im Zähler (1) beinhaltet.

8. Elektrizitätszähler mit einer Prüfeinrichtung zur Durchführung des Verfahrens nach einem der vorangehenden Ansprüche, **dadurch gekennzeichnet,** daß der Elektrizitätszähler eine optische Schnittstelle (5,6) zum Datenaustausch bei der Zählermessung nach Beaufschlagung mit einer Prüflast und einen Mikrocomputer (2) umfaßt, der bei Empfang eines Testtelegramms zur Zählermessung über die optische Schnittstelle (5,6) in einen Testbetrieb schaltet, der eine Aufschaltung von Zählerimpulsen (11,12), die in ihrer Impulswertigkeit der gemessenen Energiemenge an der Prüflast entsprechen, auf die Infrarot-Sendediode (5) der optischen Schnittstelle (5,6) bewirkt.

9. Elektrizitätszähler nach Anspruch 8, **dadurch gekennzeichnet,** daß Zustandsdaten des Elektriziätszählers durch Übertragung eines Statusworts über die optische Schnittstelle (5,6) abfragbar sind.

10. Elektrizitätszähler nach Anspruch 8 oder 9, **dadurch gekennzeichnet,** daß zur Abfrage der Zustandsdaten des Elektrizitätszählers ein weiteres Testtelegramm dient.

## Claims

1. Method for testing an electronic electricity meter (1) with optical interface (5, 6), into which a test message is entered for meter measurement after loading with a test load by way of the optical interface (5, 6), which test message effects an injection of meter pulses (11, 12) into the infrared transmitting diode (5) of the optical interface, the pulse value of which meter pulses corresponds to the measured quantity of energy at the test load.

2. Method for testing an electronic electricity meter according to claim 1, characterized in that with the input of the test message the meter pulses (12) are applied to the infrared transmitting diode (5) of the optical interface, the meter pulses (12) being supplied to a light-emitting diode (16) with a maximum operational flashing frequency of up to 15 Hz for the optical display of energy consumption.

3. Method for testing an electronic electricity meter according to claim 1 or 2, characterized in that with the test message the meter pulses (12) are applied to the infrared transmitting diode (5) for a predetermined duration and in that at the end of this duration another test message is entered into the meter (1) by way of its optical interface (5, 6), which test message leads to the output of status data of the meter (1) by way of the same optical interface (5, 6) as coded status word.

4. Method for testing an electronic electricity meter according to one of the preceding claims, characterized in that the status data are deposited in a status register.

5. Method for testing an electronic electricity meter according to claim 3 or 4, characterized in that the status interrogation takes place directly after the meter measurement if the latter has finished before the end of the predetermined duration and in that, in addition, at the end of the meter measurement the test load is disconnected, this leading to an at least temporary interruption of the flashing of the light-emitting diode (16) and in that during this interruption the test message for the status interrogation is entered into the meter (1) by way of the optical interface (5, 6).

6. Method for testing an electronic electricity meter according to one of the preceding claims, characterized in that meter pulses (11) are applied to the infrared transmitting diode (5) of the optical interface, which meter pulses have a higher pulse value compared with the meter pulses (12) which effect the flashing of the light-emitting diode (16).

7. Method for testing an electronic electricity meter according to one of the preceding claims, characterized in that the status word contains a statement on the state of the control lines of a microcomputer in the meter (1).

8. Electricity meter having a testing device for carrying out the method according to one of the preceding claims, characterized in that the electricity meter comprises an optical interface (5, 6), for data exchange during the meter measurement after the loading with a test load, and a microcomputer (2) which, upon the receiving of a test message for meter measurement, switches by way of the optical interface (5, 6) into a testing mode which effects an injection of meter pulses (11, 12) into the infrared transmitting diode (5) of the optical interface (5, 6), the pulse value of which meter pulses corresponds to the measured quantity of energy at the test load.

9. Electricity meter according to claim 8, characterized in that status data of the electricity meter can be scanned by transmission of a status word by way of the optical interface (5, 6).

10. Electricity meter according to claim 8 or 9, characterized in that another test message is used to scan the status data of the electricity meter.

## Revendications

1. Procédé de test d'un compteur (1) d'électricité électronique à interface (5, 6) optique auquel, pour la mesure de compteur, après alimentation en une charge de test, est envoyé par l'intermédiaire de l'interface (5, 6) optique un télégramme de test qui provoque un envoi, à la diode (5) émettrice infrarouge de l'interface optique, d'impulsions (11, 12) de compteur dont la valeur correspond à la quantité d'énergie mesurée présente sur la charge de test.

2. Procédé de test d'un compteur d'électricité électronique suivant la revendication 1, caractérisé en ce que, par l'envoi du télégramme de test, il est envoyé, à la diode (5) émettrice infrarouge de l'interface optique, les impulsions (12) de compteur qui sont envoyées, pour l'indication visuelle de l'énergie consommée, à une diode (16) luminescente ayant une fréquence maximale de clignotement de fonctionnement pouvant aller jusqu'à 15 Hz.

3. Procédé de test d'un compteur d'électricité électronique suivant la revendication 1 ou 2, caractérisé en ce que, par le télégramme de test, les impulsions (12) du compteur sont envoyées pour une durée prescrite à la diode (5) émettrice infrarouge et en ce que, une fois cette durée écoulée, il est envoyé au compteur (1), par l'intermédiaire de son interface (5, 6) optique, un autre télégramme de test, qui a pour conséquence la sortie en tant que mot codé d'état, par l'intermédiaire de la même interface optique, de données d'état du compteur (1).

4. Procédé de test d'un compteur d'électricité électronique suivant l'une des revendications précédentes, caractérisé en ce que les données d'état sont mémorisées dans un registre d'états.

5. Procédé de test d'un compteur d'électricité électronique suivant la revendication 3 ou 4, caractérisé en ce que la demande d'état s'effectue immédiatement à la suite de la mesure du compteur, quand il y est mis fin avant l'écoulement de la durée prescrite, et en ce que, à cet effet, lorsqu'il est mis fin à la mesure du compteur, la charge de test est débranchée, ce qui a pour conséquence d'interrompre au moins provisoirement le clignotement de la diode (16) luminescente, et en ce que, pendant cette interruption, le télégramme de test servant à la demande d'état est entré dans le compteur (1) par l'intermédiaire de l'interface (5, 6) optique.

6. Procédé de test d'un compteur d'électricité électronique suivant l'une des revendications précédentes, caractérisé en ce qu'il est envoyé à la diode (5) émettrice infrarouge de l'interface optique des impulsions (11) du compteur qui, par rapport aux impulsions (12) du compteur provoquant le clignotement de la diode (16) luminescente, ont une valeur plus grande.

7. Procédé de test d'un compteur d'électricité électronique suivant l'une des revendications précédentes, caractérisé en ce que le mot d'état contient une information sur l'état des lignes de commande d'un micro-ordinateur monté dans le compteur (1).

8. Compteur d'électricité comportant un dispositif de test pour la mise en oeuvre du procédé suivant l'une des revendications précédentes, caractérisé en ce que le compteur d'électricité comporte un interface (5, 6) optique pour l'échange données lors de la mesure du compteur après une alimentation en une charge de test et un micro-ordinateur (2) qui, à la réception d'un télégramme de test pour la mesure du compteur, est branché, par l'intermédiaire de l'interface (5, 6) optique en un fonctionnement de test qui provoque un envoi à la diode (5) émettrice infrarouge de l'interface (5, 6) optique d'impulsions (11, 12) de compteur dont la valeur correspond à la quantité d'énergie mesurée présente sur la charge de test.

9. Compteur d'électricité suivant la revendication 8, caractérisé en ce que les données d'état du compteur d'électricité peuvent être demandées par transmission d'un mot d'état par l'intermédiaire de l'interface (5, 6) optique.

10. Compteur d'électricité suivant la revendication 8 ou 9, caractérisé en ce qu'un autre télégramme de test sert à demander des données d'état du compteur d'électricité.
